(19) Europäisches Patentamt
European Patent Office
Office européen des brevets

(11) **EP 3 836 402 B1**

(12) **FASCICULE DE BREVET EUROPEEN**

(45) Date de publication et mention de la délivrance du brevet:
**31.05.2023 Bulletin 2023/22**

(21) Numéro de dépôt: **20212225.5**

(22) Date de dépôt: **07.12.2020**

(51) Classification Internationale des Brevets (IPC):
**H03H 11/04** *(2006.01)*    **H03L 7/24** *(2006.01)*
**H03L 7/099** *(2006.01)*    **H03L 7/085** *(2006.01)*
**H03D 3/00** *(2006.01)*    **H03K 3/03** *(2006.01)*

(52) Classification Coopérative des Brevets (CPC):
**H03L 7/099; H03D 3/005; H03H 11/04; H03K 3/03;**
**H03L 7/085; H03L 7/24**

(54) **FILTRE PASSE-BANDE**

BANDPASSFILTER

BAND-PASS FILTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.12.2019 FR 1914201**

(43) Date de publication de la demande:
**16.06.2021 Bulletin 2021/24**

(73) Titulaire: **Commissariat à l'Energie Atomique et aux Energies Alternatives**
**75015 Paris (FR)**

(72) Inventeurs:
• **GOUX, Nicolas**
**38054 GRENOBLE Cedex 09 (FR)**
• **BADETS, Franck**
**38054 GRENOBLE Cedex 09 (FR)**

(74) Mandataire: **Atout PI Laplace**
**Immeuble "Visium"**
**22, avenue Aristide Briand**
**94117 Arcueil Cedex (FR)**

(56) Documents cités:
**EP-A1- 1 535 395**    **FR-A1- 3 006 130**
**US-A- 5 650 749**    **US-A1- 2013 195 157**

• **MAIN E ET AL: "FM demodulation using an injection-locked oscillator", MICROWAVE SYMPOSIUM DIGEST. 2000 IEEE MTT-S INTERNATIONAL BOSTON, MA, USA 11-16 JUNE 2000, PISCATAWAY, NJ, USA,IEEE, US, 11 juin 2000 (2000-06-11), pages 135-138vol.1, XP032401806, DOI: 10.1109/MWSYM.2000.860901 ISBN: 978-0-7803-5687-0**
• **BANERJEE ABHIJIT ET AL: "Analysis of Phase-Locking in Optoelectronic Microwave Oscillators Due to Small RF Signal Injection", IEEE JOURNAL OF QUANTUM ELECTRONICS, IEEE SERVICE CENTER, PISCATAWAY, NJ, USA, vol. 53, no. 3, 1 juin 2017 (2017-06-01), pages 1-9, XP011648272, ISSN: 0018-9197, DOI: 10.1109/JQE.2017.2689745 [extrait le 2017-05-05]**

Remarques:
Le dossier contient des informations techniques présentées postérieurement au dépôt de la demande et ne figurant pas dans le présent fascicule.

**Description**

L'invention se situe dans le domaine des filtres passe-bande, et concerne plus particulièrement un tel filtre dans le domaine des phases.

De nombreuses applications en électronique ont recours à des filtres pour traiter des signaux modulés dans un rapport cyclique d'un signal carré, dits encore signaux modulés en largeur d'impulsion PWM pour « Pulse Width Modulation » selon l'anglicisme consacré.

La publication de brevet US5650749 décrit un démodulateur FM qui utilise un oscillateur à verrouillage par injection.

L'une de ces applications est celle des interfaces capteurs, en particulier les interfaces capteurs à ultra-faible consommation qui sont utilisés par exemple dans les applications médicales, telle qu'en métrologie biologique ou pour le traitement de signaux neuronaux. Plus largement, dans le domaine de l'internet des objets (IOT pour « Internet Of Things » en anglais) où il faut considérablement réduire la consommation des noeuds de capteurs, il y a besoin d'interfaces capteurs ayant une très faible consommation électrique. Pour diminuer la puissance consommée, une interface capteur est en général mise en mode veille, et n'est réactivée ou réveillée que lors de la détection d'un évènement prédéfini pour le capteur. La détection d'un évènement, qui consiste à extraire et identifier à partir d'un signal temporel des paramètres analogiques représentatifs de l'évènement, met en oeuvre une chaine de traitements de signaux dans le domaine analogique composée au moins de filtres passe-bande et de redresseurs de signaux.

Un exemple de circuit avec filtre passe-bande permettant d'extraire des paramètres d'un signal représentatif d'évènements, est décrit dans l'article de S. Oh et al., "An Acoustic Signal Processing Chip With 142-nW Voice Activity Detection Using Mixer-Based Sequential Frequency Scanning and Neural Network Classification," in IEEE Journal of Solid-State Circuits, vol. 54, no. 11, pp. 3005-3016, Nov. 2019. Ce papier présente un extracteur analogique de paramètres spectraux d'un signal. Ce circuit qui constitue l'état de l'art des extracteurs de paramètres en vue d'une détection de réveil sur évènement est composé de plusieurs canaux de filtrages. La consommation d'un seul canal de filtrage est de 5 nW, et la consommation globale du circuit est de 142 nW. Bien que cette consommation soit réduite, elle reste encore trop élevée pour des interfaces capteurs de très faible consommation, en particulier dans les réseaux bas débit.

Il existe alors un besoin pour des circuits qui permettent d'extraire des paramètres représentatifs d'événements dans un signal présentant des variations temporelles, dont la consommation est inférieure à la centaine de nanowatts.

Par ailleurs, les interfaces capteur à ultra-faible consommation doivent être robustes et fonctionner de manière fiable dans des environnements hostiles, même quand elles sont soumises à d'importantes variations de procédé de fabrication, de tension d'alimentation et de température (dites variations PVT).

Aussi, il existe le besoin pour une interface capteur à ultra-faible consommation qui soit robuste aux variations PVT.

Ainsi, un objet de l'invention est de pallier les inconvénients des techniques connues et de répondre aux besoins précités.

Pour parvenir au but recherché, il est proposé une solution à ultra-faible consommation, qui est robuste aux variations PVT, et pour laquelle le traitement des signaux est fait uniquement dans le domaine des phases.

Selon un aspect, il est proposé un filtre passe-bande agencé pour recevoir un signal d'entrée périodique modulé temporellement Vin(t), et pour délivrer un signal de sortie Vout(t), et comprenant en combinaison :

- un comparateur de phase agencé pour recevoir sur une première entrée le signal d'entrée périodique modulé temporellement Vin(t) comme premier signal, et pour générer un signal de sortie de rapport cyclique variable ; couplé à
- un oscillateur verrouillé par injection agencé pour recevoir en entrée d'injection le signal de sortie du comparateur de phase, et pour générer un signal Vr(t) déphasé par rapport au signal de sortie du comparateur de phase ;

ledit signal déphasé étant appliqué sur une deuxième entrée du comparateur de phase comme deuxième signal d'entrée ; et ledit signal de sortie du comparateur de phase étant le signal de sortie Vout(t) du filtre passe-bande et étant représentatif de la différence de phase entre les deux signaux d'entrée Vin(t) et Vr(t).

Selon des modes de réalisations particuliers indépendants ou combinés:

- le comparateur de phase comprend des circuits permettant de comparer les signaux d'entrée sur leurs fronts descendants ou sur leurs fronts montants.

- le comparateur de phase comprend au moins des bascules JK ou des bascules RS.

- le premier signal d'entrée est un signal périodique modulé en largeur d'impulsion.

- le premier signal d'entrée est un signal périodique modulé en fréquence.

- le premier signal d'entrée est un signal périodique modulé en phase.

- l'oscillateur verrouillé par injection comprend au moins des bascules RS.

- le comparateur de phase et l'oscillateur verrouillé par injection sont implémentés selon une technologie CMOS.

- le filtre comprend de plus un circuit de rétroaction couplé à l'oscillateur verrouillé par injection, afin de contrôler la phase de sortie dudit oscillateur verrouillé par injection.

Dans un autre aspect, l'invention couvre des filtres de second ordre ou plus, comprenant au moins un filtre passe-bande tel que revendiqué.

Dans un autre l'aspect, l'invention couvre un circuit d'interface pour capteur qui comprend un filtre passe-bande tel que revendiqué.

D'autres caractéristiques, détails et avantages de l'invention ressortiront à la lecture de la description faite en référence aux dessins annexés donnés à titre d'exemple et qui représentent, respectivement :

[Fig.1] schématiquement un filtre passe-bande selon un mode de réalisation de l'invention ;

[Fig.2] un graphique illustrant la modulation en largeur d'impulsion PWM d'un signal ;

[Fig.3] un chronogramme des signaux du filtre de la figure 1 selon un mode de réalisation;

[Fig.4] un graphique illustrant un diagramme de Bode du filtre de la figure 1;

[Fig.5] une implémentation d'un circuit comparateur de phase selon un mode de réalisation;

[Fig.6] un chronogramme des signaux d'entrée et de sortie d'un circuit comparateur de phase;

[Fig.7] une variante d'implémentation d'un circuit comparateur de phase ;

[Fig.8] schématiquement un oscillateur verrouillé par injection ;

[Fig9a] et

[Fig.9b] et

[Fig.9c] des variantes d'implémentation d'un oscillateur verrouillé par injection ;

[Fig.10] schématiquement un VCO à oscillateur en anneau;

[Fig.11] schématiquement un filtre passe-bande de deuxième ordre selon un mode de réalisation;

[Fig.12] un graphique illustrant un diagramme de Bode du filtre de la figure 11 ;

[Fig.13] schématiquement un circuit d'asservissement permettant la synchronisation du circuit de l'invention, selon un mode de réalisation; et

[Fig.14] une variante de réalisation du filtre passe-bande de la figure 1 comprenant le circuit d'asservissement de la figure 13.

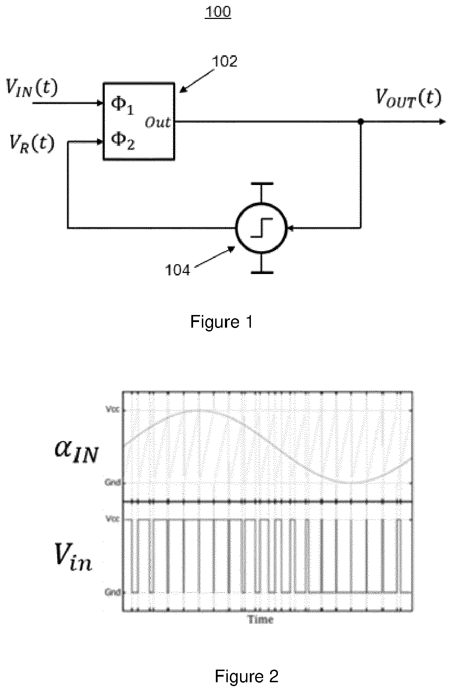

La figure 1 présente schématiquement un filtre passe-bande 100 de l'invention selon un mode de réalisation, composé d'un circuit comparateur de phase 102 et d'un oscillateur verrouillé par injection 104 ou ILO pour « Injection-Locked Oscillator » en anglais.

Le principe général de fonctionnement du dispositif de l'invention 100, consiste en ce que l'oscillateur verrouillé par injection 104 soit rebouclé par le comparateur de phase 102. Le comparateur de phase 102 reçoit un signal d'entrée $V_{in}(t)$ sur une première entrée ou entrée externe $\Phi_1$, et un second signal $V_R(t)$ sur une seconde entrée ou entrée interne $\Phi_2$.

Le signal d'entrée $V_{IN}(t)$ est un signal périodique modulé, qui présente des variations temporelles, c'est-à-dire un signal périodique modulé en fréquence, en phase ou en largeur d'impulsion ou tout autre type de modulation impliquant un déplacement des fronts du signal d'entrée $V_{IN}(t)$. Le comparateur de phase effectue la comparaison des phases des signaux d'entrée, soit des fronts de même nature (fronts montants ou descendants) quand la modulation est en phase ou en fréquence, ou si la modulation est en largeur d'impulsion, il effectue la comparaison sur la distance entre deux positions temporelles des signaux d'entrée (entre deux fronts de nature différente).

Dans le mode de réalisation décrit, le signal d'entrée $V_{IN}(t)$ est un signal périodique modulé en largeur d'impulsion (PWM) dont le rapport cyclique est variable. Dans d'autres modes de réalisation, les mêmes principes de fonctionnement du dispositif de l'invention s'appliquent à un signal d'entrée périodique modulé en fréquence ou en phase.

Différentes méthodes connues peuvent être mise en oeuvre pour obtenir un signal d'entrée modulé. Pour moduler un signal en phase, il est possible d'utiliser un ILO comme simple déphaseur dynamique, de le verrouiller sur un signal de verrouillage, et contrôler son déphasage de sortie dynamiquement par une tension de contrôle. La modulation en largeur d'impulsion PWM, peut être obtenue par comparaison d'un signal modulant à une rampe, ou être une modulation PWM à ILO. Un modulateur PWM à ILO est constitué d'un ILO et d'un comparateur de phase. Son fonctionnement est le suivant : un ILO est verrouillé par un signal $V_{LOCK}$ à une fréquence $f_{LOCK}$. Un déphasage statique apparaît entre le signal de sortie de l'ILO $V_{ILO}$, et $V_{LOCK}$. Ce déphasage est contrôlé dynamiquement par un signal modulant $V_{CTRL}$ appliqué sur l'entrée de contrôle dynamique de l'ILO. Les phases des signaux $V_{LOCK}$ et $V_{ILO}$ sont comparées par le comparateur de phase (réagissant sur front montant ou descendant). Le signal résultant $V_{PWM}$ est un signal de rapport cyclique variable, proportionnel au déphasage $\Delta\Phi$ d'un rapport $2\pi$. En appelant $\alpha_{PWM}$ le rapport cyclique de $V_{PWM}$, on a

$$\alpha_{PWM} = \frac{\Delta\Phi}{2\pi}.$$

La figure 2 illustre une modulation en largeur d'impulsion d'un signal $V_{in}$ par un modulant $\alpha_{IN}$, où il peut être observé que l'information modulée est contenue dans la variation du rapport cyclique des signaux.

Revenant à la figure 1, le comparateur de phase 102 délivre sur une sortie *Out* un signal de sortie $V_{OUT}(t)$. Le signal de sortie $V_{OUT}(t)$ devient aussi l'entrée de verrouillage de l'oscillateur verrouillé par injection 104.

L'oscillateur verrouillé par injection 104 délivre un signal $V_R(t)$ qui est appliqué sur une deuxième entrée ou entrée interne $\Phi_2$ du comparateur de phase, comme deuxième signal d'entrée.

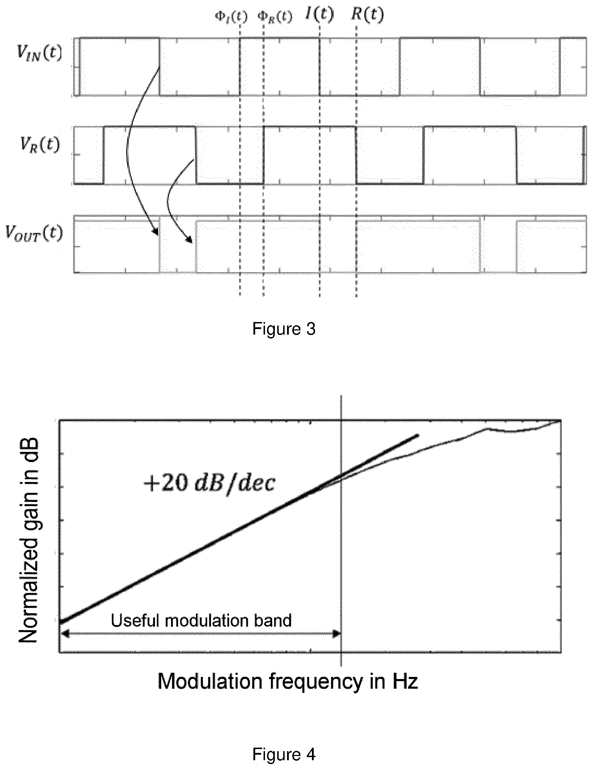

La figure 3 illustre un chronogramme des signaux d'entrée $V_{IN}(t)$, $V_R(t)$ et de sortie $V_{OUT}(t)$ du comparateur de phase 104 du filtre passe-bande de la figure 1.

Les différentes références illustrées sur la figure 3 sont :

- $\Phi_I(t)$ : la phase du signal d'entrée $V_{IN}(t)$, représentée par la position de son front montant.

- $\Phi_R(t)$ : la phase du signal d'entrée $V_R(t)$, représentée par la position de son front montant.

- $I(t)$ : la variation de position angulaire du front descendant du signal $V_{IN}(t)$.

- $R(t)$ : la variation de position angulaire du front descendant du signal $V_R(t)$.

Le comparateur de phase 102 a un fonctionnement séquentiel : il détecte d'abord le passage en front descendant du premier signal d'entrée $V_{IN}(t)$ appliqué sur la première entrée $\Phi_1$ pour inverser la valeur du signal de sortie $V_{OUT}(t)$, puis rester à cette valeur jusqu'à détecter le passage en front descendant du deuxième signal d'entrée $V_R(t)$ appliqué sur la deuxième entrée $\Phi_2$ pour inverser la valeur du signal de sortie $V_{OUT}(t)$. On peut ainsi observer le rapport cyclique du signal de sortie $V_{OUT}(t)$.

Le comparateur de phase 102 reconstitue une modulation en largeur d'impulsion PWM résultant de la différence de phase entre les fronts descendants des signaux d'entrée $V_{IN}(t)$ et $V_R(t)$ appliqués respectivement sur les entrées $\Phi_1$ et $\Phi_2$. Le résultat de la comparaison des phases est le signal de sortie $V_{OUT}(t)$ qui a un rapport cyclique variable représentatif de la différence de phase entre les signaux d'entrée $V_{IN}(t)$ et $V_R(t)$. Le rapport cyclique du signal de sortie $V_{OUT}(t)$ est ainsi la dérivée du rapport cyclique du signal d'entrée $V_{IN}(t)$. Le signal de sortie $V_{OUT}(t)$ est un signal modulé en largeur d'impulsion qui contient l'information à traiter.

Avantageusement, le circuit de l'invention par la combinaison des deux circuits - le comparateur de phase 104 et l'oscillateur verrouillé par injection 102 - permet de réaliser une dérivation du rapport cyclique du signal de sortie. Le dispositif proposé est simple car n'étant constitué que de deux éléments : un comparateur de phase couplé à un oscillateur verrouillé par injection selon l'agencement décrit.

La figure 4 montre un diagramme de Bode issu d'une simulation électrique du circuit 100 de l'invention selon un mode de réalisation tel que celui de la figure 1. Un signal carré modulé en largeur d'impulsion a été appliqué sur l'entrée externe du comparateur de phase afin d'observer le rapport cyclique du signal de sortie. Le graphique de la figure 4 présente le tracé du gain du montage $G_{dB}$, c'est-à-dire l'amplitude de la variation du rapport cyclique du signal de sortie, normalisée par l'amplitude de la variation du rapport cyclique du signal d'entrée. Il peut être observé une pente de $_+20$ db/décade qui est caractéristique du comportement dérivateur du système. On peut définir une bande de modulation utile comme étant l'intervalle de fréquence de modulation sur lequel le dérivateur peut être approximé comme idéal.

Avantageusement, le dispositif peut être synchronisé sur la fréquence du signal d'entrée, pour éviter l'utilisation d'un oscillateur de référence additionnel pour détecter la phase du signal de sortie, comme dans les dispositifs connus.

La fréquence de coupure du circuit dépendant de grandeurs paramétrables facilement (par exemple par la taille de capacités), il est possible de faire varier la fréquence de coupure et le gain du montage.

Dans un mode de réalisation, la plage de verrouillage de l'oscillateur verrouillé par injection 102 peut être réglée selon les besoins d'une application, ce qui permet au circuit de rester verrouillé sur une large gamme de fréquence. Ceci assure une robustesse du système face aux variations de procédé, de tension et de température. Dans une utilisation pour interface capteur dans des milieux présentant des variations de température, le circuit peut avantageusement être alimenté sur une batterie dont la tension d'alimentation diminue au cours du temps.

Dans un mode de réalisation, le comparateur de phase 104 qui permet de comparer la phase des signaux d'entrée $V_{IN}(t)$ et $V_R(t)$ sur leur front descendant, est réalisé à base de bascules JK. L'homme du métier pourra envisager différentes implémentations élémentaires du comparateur de phase afin de l'adapter à la détection sur la nature du front actif choisi, qu'il soit montant ou descendant.

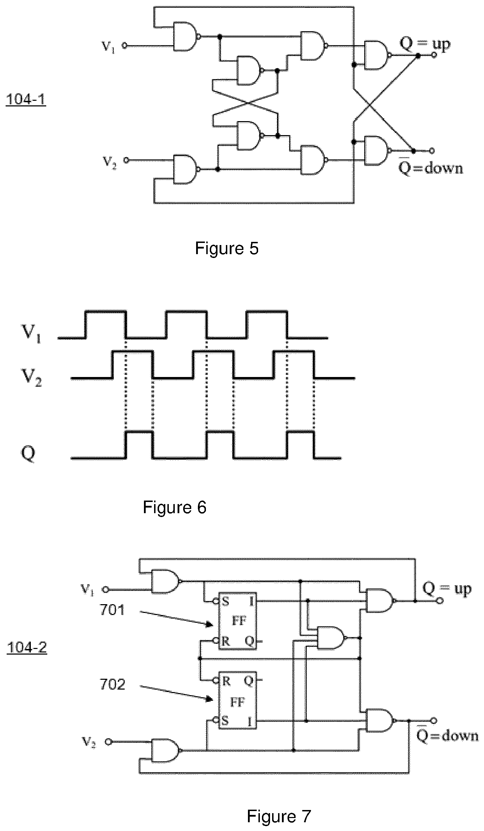

La figure 5 illustre un exemple d'un circuit 104-1 à base de bascule JK implémenté avec des portes NAND. Le circuit comprend deux entrées $V_1$ et $V_2$ dont la phase est comparée, et délivre une sortie Q. La sortie inverse est notée $\overline{Q}$. La figure 6 montre un chronogramme des signaux d'entrée $V_1$ et $V_2$ et du signal de sortie Q de la bascule JK de la figure 5 où l'on peut observer le basculement du signal de sortie lors de la détection des fronts descendants de chacun des signaux d'entrée $V_1$ et $V_2$. Ce type de comparateur de phase est un circuit numérique fonctionnant avec des signaux carrés.

Dans un autre mode de réalisation, le comparateur de phase peut être basé sur des bascules RS. La figure 7 illustre schématiquement un exemple connu d'implémentation d'un comparateur de phase 104-2 à double bascule RS (701, 702) ayant deux entrées V1 et V2 et délivrant une sortie Q et la sortie inverse $\overline{Q}$.

L'homme du métier comprend que les exemples d'implémentation des figures 5 et 7 ne sont pas limitant et que toute variante de réalisation peut être considérée, qu'elle soit à base de bascules JK ou bascules RS, en commande sur front actif (montant ou descendant). Par ailleurs, tout comparateur de phases réalisé avec des portes logiques n'est pas limitant pour la bande passante. En effet, les portes logiques peuvent être implémentées dans différentes technologies, aussi bien en logique CMOS qu'en logique CML ou autre, avec une bande passante pouvant aller jusqu'à plusieurs GHz.

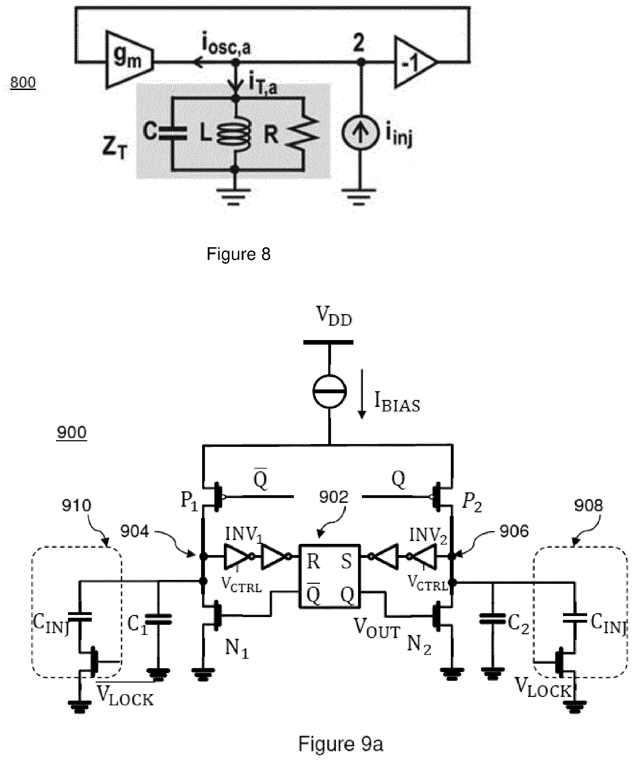

La figure 8 illustre un schéma de principe d'un modèle d'oscillateur verrouillé par injection 800. De manière connue, un oscillateur verrouillé par injection (ILO) est un type d'oscillateur qui a une fréquence d'oscillation libre $f_0$ lorsqu'aucun signal d'entrée ne lui est appliqué, et quand un signal de synchronisation lui est appliqué avec une fréquence $f_{lock}$ qui se trouve dans certaines limites par rapport à la fréquence $f_0$, l'oscillateur se verrouille sur cette fréquence. Dans l'exemple de la figure 8, l'ILO qui est représenté avec des composants idéaux, est un ILO harmonique dont le signal de synchronisation qui est appliqué est un courant d'injection $I_{inj}$ qui permet à l'oscillateur de suivre la fréquence de synchronisation ou d'injection. Les blocs « -1 », « $g_m$ » et « R,L,C » représentent un oscillateur dont le signal de sortie est relevé sur le point « 2 ». Le courant $I_{inj}$ correspond au courant d'injection. C'est un signal analogique ayant une amplitude déterminée, et oscillant à la fréquence de synchronisation $f_{lock}$ (ou $f_{inj}$)

Le principe d'injection décrit est commun à tous les oscillateurs de type ILO utilisés pour différentes applications, comme les divisions ou multiplications de fréquence, la calibration en fréquence ou encore dans des boucles à phase asservie (PLL) pour « Phase Locked Loop » en anglais. Les articles suivants présentent différents oscillateurs ILO :

- R. Adler, "A Study of Locking Phenomena in Oscillators," in Proceedings of the IRE, vol. 34, no. 6, pp. 351-357, June 1946. doi: 10.1109/JRPROC.1946.229930 ;

- F. Yuan, "Injection-Locking in Mixed-Mode Signal Processing", Springer, 2020. Doi : https://doi.org/10.1007/978-3-030-17364-7

La figure 9a montre une implémentation d'un oscillateur verrouillé par injection 900 selon un mode de réalisation du circuit de l'invention. L'ILO 900 est basé sur une bascule de type RS 902 ayant des entrées R et S et des sorties Q et $\overline{Q}$. Par analogie avec la figure 1, les entrées de l'ILO correspondent au signal $V_{OUT}(t)$ de sortie du comparateur de phase 102. L'entrée R est couplée par l'intermédiaire d'une connexion série d'une paire d'inverseurs, à un noeud intermédiaire capacitif 904 entre deux transistors $P_1$, $N_1$. Le noeud intermédiaire 904 est couplé à une capacité de charge $C_1$. L'entrée S est couplée par l'intermédiaire d'une connexion série d'une autre paire d'inverseurs, à un noeud intermédiaire capacitif 906 entre deux transistors $P_2$, $N_2$. Le noeud intermédiaire 906 est couplé à une capacité de charge $C_2$.

La sortie Q de la bascule RS fournit un signal de sortie $V_{OUT}$, correspondant par analogie avec la figure 1 au signal $V_R(t)$ de l'ILO 104 qui est injecté dans le comparateur de phase 102. La sortie Q est couplée à la grille du transistor $N_2$, qui peut être par exemple un transistor MOS à canal N (NMOS), couplé par ses noeuds de conduction principaux entre le noeud intermédiaire 906 et la masse. La sortie Q est de plus couplée à la grille du transistor $P_2$, qui peut être par exemple un transistor MOS à canal P (PMOS), couplé par ses noeuds de conduction principaux entre le noeud intermédiaire 906 et une tension d'alimentation $V_{DD}$ par l'intermédiaire d'une source de courant fournissant un courant $I_{BIAS}$.

La sortie $\overline{Q}$ de la bascule RS 902 fournit un signal de sortie inversé. De manière similaire, elle est couplée à la grille du transistor $N_1$, qui peut être par exemple un transistor MOS à canal N (NMOS), couplé par ses noeuds de conduction principaux entre le noeud intermédiaire 904 et la masse. La sortie $\overline{Q}$ est de plus couplée à la grille du transistor $P_1$, qui peut être par exemple un transistor MOS à canal P (PMOS), couplé par ses noeuds de conduction principaux entre le noeud intermédiaire 904 et la tension d'alimentation $V_{DD}$ par l'intermédiaire de la source de courant fournissant le courant $I_{BIAS}$.

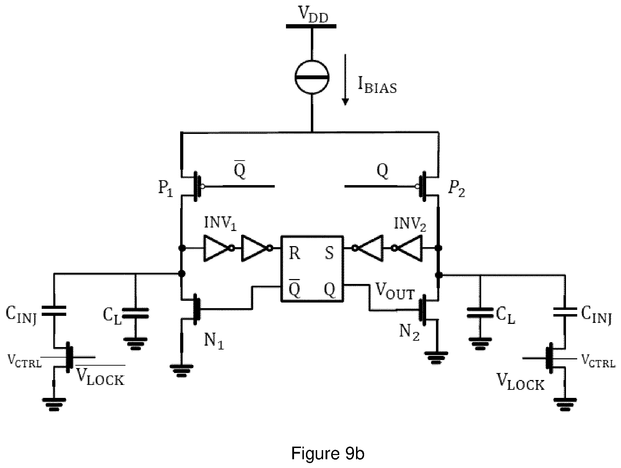

L'ILO comprend de plus un circuit de verrouillage composé de deux assemblages symétriques, similaires 908, 910. Chaque assemblage comprend de manière identique une capacité d'injection $C_{INJ}$ couplée entre le noeud intermédiaire, respectivement 904 ou 908, et la masse par l'intermédiaire d'un transistor de contrôle recevant sur son entrée un signal de verrouillage, respectivement $V_{LOCK}$, $\overline{V_{LOCK}}$. Chaque transistor de contrôle constitue un « switch » dont la conductivité peut être modifiée par le contrôle de sa tension de substrat. Cette tension $V_{CTRL}$ peut être appliquée sur son substrat s'il s'agit d'un transistor implémentée dans une technologie CMOS classique, ou sur sa face arrière s'il s'agit d'un transistor implémenté dans une technologie FDSOI, tel que représenté sur la figure 9b. Le signal $V_{CTRL}$ modifie la conductivité des transistors des assemblages de verrouillage 908 et 910, impliquant un courant de fuite dans les branches correspondantes. Ce courant de fuite permet de faire varier la pente de charge des capacités d'injection $C_{INJ}$. Cette variation de pente entraîne un contrôle dynamique du déphasage de l'ILO.

Comme indiqué précédemment, l'ILO rebouclé sur le comparateur de phase, crée une dérivation de phase du signal de sortie $V_{OUT}(t)$ du comparateur de phase pour générer le signal $V_R(t)$ dont la phase est comparée à celle du signal d'entrée $V_{IN}(t)$ du comparateur de phase.

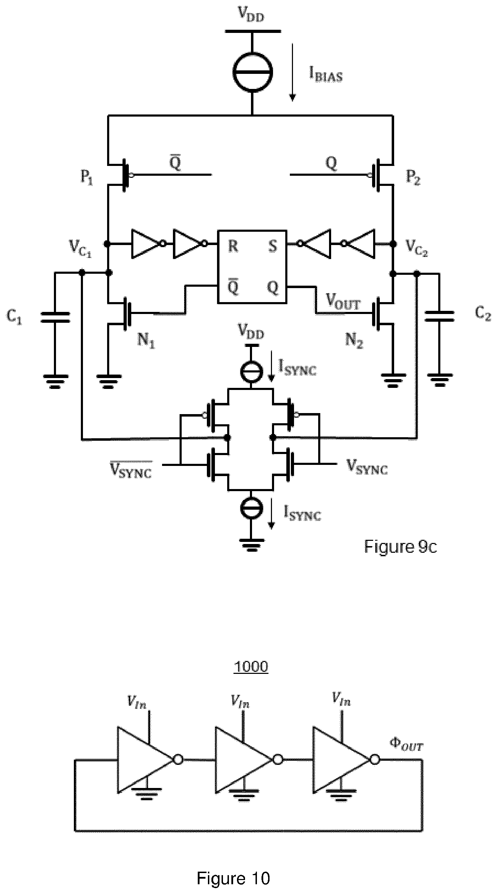

La figure 9c illustre une autre variante d'implémentation d'un oscillateur verrouillé par injection.

Les équations suivantes (1) à (6) permettent de démontrer le fonctionnement du circuit de l'invention, i.e. écrire sa fonction de transfert (7). Les différents termes utilisés dans les équations prennent les définitions ci-après :

- $\Phi_I(t)$ : la phase du signal d'entrée $V_{IN}(t)$, représentée par la position de son front non actif.

- $\alpha_I(t)$ : le rapport cyclique du signal d'entrée $V_{IN}(t)$.

- $\Phi_R(t)$ : la phase du signal $V_R(t)$, représentée par son front non actif.

- $\alpha_R(t)$ : le rapport cyclique du signal $V_R(t)$.

- **K** est le coefficient de proportionnalité entre $\Phi_R$ et la fréquence de synchronisation $f_{lock}$ lorsqu'elle est constante.

- $R(t)$ et $I(t)$ : la position angulaire respectivement des fronts actifs des signaux $V_R(t)$ et $V_{IN}(t)$.

- $\overline{V_{OUT}}$ : le signal de sortie inversé.

En considérant que la phase du signal d'entrée est nulle, il est possible d'écrire :

$$I(t) = 2\pi \left( \alpha_{IN}(t) - \frac{1}{2} \right) \quad (1).$$

Le rapport cyclique $\overline{\alpha}(t)$ du signal $\overline{V_{OUT}}$ se définit par :

$$\bar{\alpha}(t) = \frac{R(t) - I(t)}{2\pi} \quad (2).$$

Par une approximation aux petits signaux, on peut considérer que l'équation de fonctionnement d'un ILO lorsque son signal de synchronisation est modulé en phase peut s'écrire :

$$\tau \frac{d\Phi_{ILO}}{dt} + \Phi_{ILO} = \frac{K}{2\pi} \frac{d\Phi_{SYNC}}{dt} \quad (3),$$

où la phase $\Phi_{ILO}$ du signal de sortie s'écrit comme la dérivée du signal de synchronisation.

En posant pour hypothèse que l'ILO réagit sur la position angulaire du front descendant de $V_{OUT}$, elle-même égale à $(t)$, et en prenant en compte la variation de position angulaire $R(t) - I(t)$ en sortie de l'ILO car elle est référencée par rapport au signal de synchronisation, l'équation (3) devient :

$$\tau \frac{d(R(t) - I(t))}{dt} + \left(R(t) - I(t)\right) = \frac{K}{2\pi} \frac{dI(t)}{dt} \quad (4).$$

En combinant l'équation (4) avec l'équation (2), on obtient :

$$\tau \frac{d\bar{\alpha}}{dt} + 2\pi \bar{\alpha} = K \frac{d\alpha_{IN}}{dt} \quad (5).$$

Puis en effectuant la transformée de Laplace de l'équation (5), on obtient :

$$\frac{\bar{\alpha}(p)}{\alpha_{IN}(p)} = \frac{K}{2\pi} \cdot \frac{p}{1 + \tau p} \quad (6).$$

En considérant que $\alpha(t) = 1 - \overline{\alpha(t)}$, on considère alors que $\alpha(p) = -\overline{\alpha}(p)$. La fonction de transfert du filtre s'écrit donc selon l'équation suivante :

$$\frac{\alpha(p)}{\alpha_{IN}(p)} = -\frac{K}{2\pi} \cdot \frac{p}{1 + \tau p} \quad (7),$$

qui régit le comportement du filtre avec une constante de temps $\tau$.

Une application avantageuse du circuit de l'invention est celle des filtres dans le domaine temporel. Les techniques connues de filtrage de signaux à modulation de largeur d'impulsions PWM utilisent principalement des filtres à oscillateur en anneau RO (« Ring Oscillator » en anglais). Un oscillateur contrôlé en tension VCO (« Voltage Control Oscillator » en anglais) composé de ROs peut être utilisé comme un intégrateur. La figure 10 montre schématiquement un VCO à oscillateur en anneau 1000 dont la fréquence de sortie $f_{out}$ qui est contrôlée par la tension de contrôle $V_{in}$, s'écrit :

$$f_{out} = K_{VCO} V_{in} \quad (8).$$

La phase de sortie $\Phi_{OUT}$ du VCO est définie par l'équation :

$$f_{out} = \frac{1}{2\pi} \frac{d\Phi_{out}}{dt} \quad (9).$$

En effectuant la transformée de Laplace de l'équation (9), on obtient l'équation suivante :

$$\frac{\Phi_{\text{out}}(p)}{V_{in}(p)} = 2\pi \frac{K_{\text{VCO}}}{p} \ (10).$$

La phase du signal de sortie $\Phi_{out}$ est donc l'image du signal $V_{in}$ intégré. Ceci démontre qu'un oscillateur contrôlé en tension VCO est un bloc qui peut être utilisé comme bloc intégrateur d'un signal analogique dans le domaine des phases. Ce bloc peut être rebouclé à l'aide d'un comparateur de phase pour synthétiser une fonction de transfert.

L'article de Leene, Lieuwe B. and Timothy G. Constandinou. "Time Domain Processing Techniques Using Ring Oscillator-Based Filter Structures." IEEE Transactions on Circuits and Systems I: Regular Papers 64 (2017): 3003-3012, propose d'utiliser un VCO en anneau rebouclé, pour synthétiser une fonction de transfert d'un filtre de premier ordre de pulsation de coupure $k_1$ (constante dépendant des paramètres du filtre), sous la forme de l'équation suivante :

$$F(p) = \frac{1}{1+\frac{p}{k_1}} \ (11).$$

Ainsi un VCO peut être utilisé comme bloc principal pour la synthèse de filtre dans le domaine temporel, avec des composants additionnels (comparateur de phase, portes logiques). Ce type de filtre peut être étendu à des fonctions de transfert d'ordre plus élevées. Le fonctionnement d'un filtre du second ordre est analogue à celui d'un filtre d'ordre 1, avec l'utilisation de composants supplémentaires.

L'article précité de Leene, présente un filtre passe-bande du second ordre agissant sur des signaux modulés en largeur d'impulsion. Sa grandeur d'entrée est un rapport cyclique, et sa grandeur de sortie est aussi un rapport cyclique. Bien que la consommation pour ce filtre soit inférieure à la centaine de nW (donnée pour 73 nW), il présente des inconvénients.

En effet, l'utilisation d'un VCO amène un bruit de phase intrinsèque car les circuits ne sont pas synchronisés. Une conversion phase vers analogique est nécessaire pour réaliser une seconde intégration, et obtenir la synthèse de filtre analogique du second ordre.

- Par ailleurs, cette architecture nécessite l'utilisation de nombreux composants, qui sont pour un filtre de second ordre, au moins :

  - deux comparateurs de phase : une porte XOR et un comparateur ;
  - des sources de courant commutées, pour une utilisation analogue à une pompe de charge permettant de créer le courant de contrôle de l'oscillateur ;
  - une phase de référence opérant à la même fréquence que l'oscillateur en anneau (circuits non synchronisés) ;
  - des capacités et des transistors pour réaliser une intégration pour la génération du filtre du second ordre. Ceci rend par ailleurs le circuit sensible aux variations PVT.

L'utilisation de plusieurs composants entraine de surcroit de nombreux courants dynamiques lors des commutations de transistors amenant une consommation plus importante et des fuites de courant dans le circuit.

Aussi, avantageusement, le dispositif 100 de l'invention permet de simplifier l'architecture des filtres dans le domaine temporel, en n'utilisant que deux composants, un oscillateur verrouillé par injection ILO rebouclé par un comparateur de phase.

Toujours avantageusement, le dispositif de l'invention permet un traitement du signal uniquement dans le domaine des phases (mesure différentielle des déphasages) où l'ILO est utilisé comme bloc élémentaire de dérivation sur sa bande utile, permettant ainsi une diminution du bruit de phase.

Enfin, comme le circuit de l'invention traite un signal dans le domaine des phases, la dynamique de l'information à traiter ne dépend pas de l'amplitude du signal Vin(t) mais de la position temporelle de son front descendant, qui peut changer grâce à une modulation, soit en fréquence, soit en phase, soit en largeur d'impulsion. L'amplitude des signaux Vin(t) et Vout(t) peut alors être diminuée sans changer leur rapport signal sur bruit, et par conséquent, la tension d'alimentation du circuit peut être diminuée. Comme la consommation du circuit dépend du carré de la tension d'alimentation, celle-ci est alors efficacement réduite par le dispositif de l'invention. En simulation, pour un circuit verrouillé à 32 kHz, la consommation simulée du circuit de l'invention est de 1,8 nW, pour un bruit de phase intégré de 0.11°.

Aussi, comparativement au circuit du papier précité de Leene, la réduction du nombre de composants permet de réduire les fuites de courant dans le circuit, ainsi que les courants dynamiques liées aux commutations des transistors, et permet également de baisser la consommation.

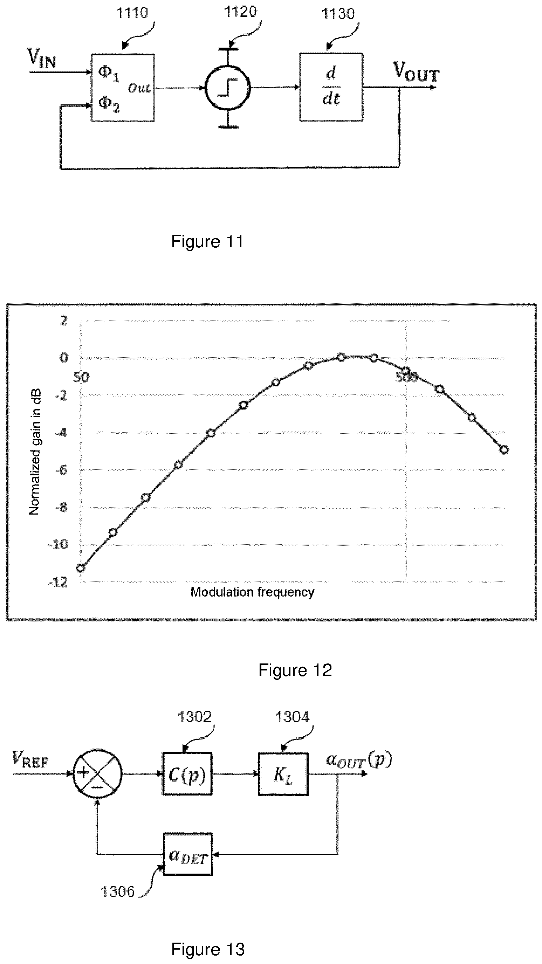

La figure 11 illustre l'architecture d'un filtre 1100 du second ordre à ILO, agissant sur un signal d'entrée $V_{IN}$ modulé en PWM, et dont le signal de sortie $V_{OUT}$ est également un signal modulé en PWM, composé d'un comparateur de phase 1110, d'un ILO 1120 et d'un bloc dérivateur 1130. Les simulations d'un filtre du second ordre réalisé selon les principes de l'invention, donnent une consommation de l'ordre de 3 nW, bien inférieure à la consommation des circuits de l'art antérieur, et sa réponse en fréquence, pour un rapport cyclique en entrée d'amplitude constante et variant en fréquence, est montrée sur la figure 12.

Dans un mode de réalisation, afin d'apporter une stabilisation du rapport cyclique de sortie au repos en fonction de la température, le dispositif de l'invention comprend une boucle de rétroaction. En effet, le rapport cyclique du signal de sortie, au repos, peut être variable en fonction de la température. Pour contrer ce phénomène, il est possible de l'ajuster en contrôlant la phase à l'équilibre du signal de sortie de l'ILO (la phase de l'ILO lorsque le rapport cyclique d'entrée du dérivateur est constant, et donc que le circuit fonctionne en régime statique). L'ajout d'une boucle de rétroaction permet de contrôler la phase de sortie de l'ILO dans le but de maintenir le rapport cyclique du dérivateur constant en fonction de la température. Cette boucle prend l'aspect d'un asservissement classique comme illustré schématiquement sur la figure 13, où sont définis les blocs et termes suivants :

- $V_{REF}$ : le signal de commande de phase initial en V ;

- $C(p)$ (1302) : la fonction de transfert d'un correcteur de l'asservissement ;

- $K_L = \dfrac{\Phi_{ILO}}{V_{CTRL}}$ (1304) : le coefficient de proportionnalité en 1/V entre le rapport cyclique de sortie et le signal de contrôle de l'ILO ;

- $\alpha_{DET} = \dfrac{V_r}{\alpha_{OUT}}$ (1306) : le coefficient de proportionnalité en V entre le rapport cyclique de sortie du dérivateur et le signal de retour de la boucle de rétroaction. Ce bloc peut être réalisé par une pompe de charge.

- $\alpha_{OUT}$ : rapport cyclique de sortie.

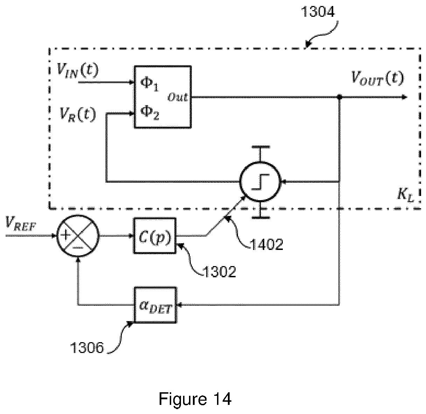

La figure 14 illustre une implémentation du circuit de l'invention asservi avec une boucle de rétroaction selon la figure 13. Le rapport cyclique du signal de sortie $V_{OUT}$ est détecté par le bloc 1306 $\alpha_{DET}$ et converti en une tension continue. Il est ensuite comparé à une tension $V_{REF}$ par l'intermédiaire d'un amplificateur d'erreur. Le résultat est ensuite filtré 1302 et transmis sur l'entrée 1402 de contrôle de l'ILO. L'ensemble forme un asservissement dont la commande est $V_{REF}$ et qui permet ainsi la stabilité en température, dans la mesure où le rapport cyclique de sortie $V_{OUT}$ suivra la commande $V_{REF}$.

La présente description illustre une implémentation préférentielle de l'invention, mais qui n'est pas limitative. Des exemples sont choisis pour permettre une bonne compréhension des principes de l'invention et une application concrète, mais ne sont en rien exhaustifs et doivent permettre à l'homme du métier d'apporter des modifications et des variantes d'implémentation en conservant la même portée de l'invention comme définie par les revendications annexées.

**Revendications**

**1.** Filtre passe-bande (100) agencé pour recevoir un signal d'entrée périodique modulé temporellement Vin(t), et pour délivrer un signal de sortie Vout(t), comprenant en combinaison :

- un comparateur de phase (102) agencé pour recevoir sur une première entrée le signal d'entrée périodique modulé temporellement Vin(t) comme premier signal, et pour générer un signal de sortie de rapport cyclique variable ; couplé à
- un oscillateur verrouillé par injection (104) agencé pour recevoir en entrée d'injection le signal de sortie du comparateur de phase, et pour générer un signal Vr(t) déphasé par rapport au signal de sortie du comparateur de phase ;
ledit signal déphasé étant appliqué sur une deuxième entrée du comparateur de phase (102) comme deuxième signal d'entrée ; et
ledit signal de sortie du comparateur de phase étant le signal de sortie Vout(t) du filtre passe-bande et étant représentatif de la différence de phase entre les deux signaux d'entrée Vin(t) et Vr(t).

**2.** Filtre selon la revendication 1 dans lequel le comparateur de phase comprend des circuits permettant de comparer les signaux d'entrée sur leurs fronts descendants ou sur leurs fronts montants.

**3.** Filtre selon la revendication 1 ou 2 dans lequel le comparateur de phase comprend au moins des bascules JK ou des bascules RS.

**4.** Filtre selon l'une quelconque des revendications précédentes dans lequel le premier signal d'entrée est un signal périodique modulé en largeur d'impulsion.

**5.** Filtre selon l'une quelconque des revendications 1 à 3 dans lequel le premier signal d'entrée est un signal périodique modulé en fréquence.

**6.** Filtre selon l'une quelconque des revendications 1 à 3 lequel le premier signal d'entrée est un signal périodique modulé en phase.

**7.** Filtre selon l'une quelconque des revendications précédentes dans lequel l'oscillateur verrouillé par injection comprend au moins des bascules RS.

**8.** Filtre selon l'une quelconque des revendications précédentes dans lequel le comparateur de phase et l'oscillateur verrouillé par injection sont implémentés selon une technologie CMOS.

**9.** Filtre selon l'une quelconque des revendications précédentes comprenant de plus un circuit de rétroaction couplé à l'oscillateur verrouillé par injection, afin de contrôler la phase de sortie dudit oscillateur verrouillé par injection.

**10.** Filtre de second ordre ou plus, comprenant au moins un filtre passe-bande selon l'une quelconque des revendications précédentes.

**11.** Circuit d'interface pour capteur comprenant un filtre passe-bande selon l'une quelconque des revendications 1 à 10.

**Patentansprüche**

**1.** Bandpassfilter (100), das zum Empfangen eines zeitlich modulierten periodischen Eingangssignals Vin(t) und zum Liefern eines Ausgangssignals Vout(t) ausgelegt ist, in Kombination Folgendes umfassend:

- einen Phasenkomparator (102), der zum Empfangen des zeitlich modulierten periodischen Eingangssignals Vin(t) als erstes Signal an einem ersten Eingang und zum Erzeugen eines Ausgangssignals mit variablem Tastverhältnis ausgelegt ist; gekoppelt mit
- einem injektionsverriegelten Oszillator (104), der zum Empfangen des Ausgangssignals des Phasenkomparators als Injektionseingabe und zum Erzeugen eines Signals Vr(t) ausgelegt ist, das in Bezug auf das Ausgangssignal des Phasenkomparators phasenverschoben ist;
wobei das Phasensignal an einen zweiten Eingang des Phasenkomparators (102) als zweites Eingangssignal angelegt wird; und
wobei das Ausgangssignal des Phasenkomparators das Ausgangssignal Vout(t) des Bandpassfilters und für die Phasendifferenz zwischen den beiden Eingangssignalen Vin(t) und Vr(t) repräsentativ ist.

**2.** Filter nach Anspruch 1, wobei der Phasenkomparator Schaltungen zum Vergleichen der Eingangssignale an ihren abfallenden Flanken oder an ihren ansteigenden Flanken umfasst.

**3.** Filter nach Anspruch 1 oder 2, wobei der Phasenkomparator mindestens JK-Flipflops oder RS-Flipflops umfasst.

**4.** Filter nach einem der vorhergehenden Ansprüche, wobei das erste Eingangssignal ein pulsbreitenmoduliertes Periodensignal ist.

**5.** Filter nach einem der Ansprüche 1 bis 3, wobei das erste Eingangssignal ein frequenzmoduliertes Periodensignal ist.

**6.** Filter nach einem der Ansprüche 1 bis 3, wobei das erste Eingangssignal ein phasenmoduliertes Periodensignal ist.

**7.** Filter nach einem der vorhergehenden Ansprüche, wobei der injektionsverriegelte Oszillator mindestens RS-Flipflops umfasst.

**8.** Filter nach einem der vorhergehenden Ansprüche, wobei der Phasenkomparator und der injektionsverriegelte Oszillator unter Verwendung von CMOS-Technologie implementiert sind.

**9.** Filter nach einem der vorhergehenden Ansprüche, das außerdem eine Rückkopplungsschaltung umfasst, die mit dem injektionsverriegelten Oszillator gekoppelt ist, um die Ausgangsphase des injektionsverriegelten Oszillators zu steuern.

**10.** Filter zweiter oder höherer Ordnung, das mindestens ein Bandpassfilter nach einem der vorhergehenden Ansprüche umfasst.

**11.** Schnittstellenschaltung für einen Sensor, der ein Bandpassfilter nach einem der Ansprüche 1 bis 10 umfasst.

**Claims**

**1.** A bandpass filter (100) arranged to receive a temporally modulated periodic input signal Vin(t), and to deliver an output signal Vout(t), comprising, in combination:

- a phase comparator (102) arranged to receive, on a first input, the temporally modulated periodic input signal Vin(t) as first signal, and to generate an output signal with a variable duty cycle; coupled to
- an injection-locked oscillator (104) arranged to receive as injection input, the output signal from the phase comparator, and to generate a signal Vr(t) that is phase-offset with respect to the output signal of the phase comparator;

said phase-offset signal being applied to a second input of the phase comparator (102) as second input signal; and said output signal of the phase comparator being the output signal Vout(t) of the bandpass filter and being representative of the phase difference between the two input signals Vin(t) and Vr(t).

**2.** The filter according to claim 1, wherein the phase comparator comprises circuits for comparing the input signals on their falling edges or on their rising edges.

**3.** The filter according to claim 1 or 2, wherein the phase comparator comprises at least JK flip-flops or RS flip-flops.

**4.** The filter according to any one of the preceding claims, wherein the first input signal is a pulse width-modulated periodic signal.

**5.** The filter according to any one of claims 1 to 3, wherein the first input signal is a frequency-modulated periodic signal.

**6.** The filter according to any one of claims 1 to 3, wherein the first input signal is a phase-modulated periodic signal.

**7.** The filter according to any one of the preceding claims, wherein the injection-locked oscillator comprises at least RS flip-flops.

**8.** The filter according to any one of the preceding claims, wherein the phase comparator and the injection-locked oscillator are implemented using CMOS technology.

**9.** The filter according to any one of the preceding claims, additionally comprising a feedback circuit coupled to the injection-locked oscillator in order to control the output phase of said injection-locked oscillator.

**10.** A second-order or higher-order filter, comprising at least one bandpass filter according to any one of the preceding claims.

**11.** An interface circuit for a sensor comprising a bandpass filter according to any one of claims 1 to 10.

100

102

$V_{IN}(t)$

$\Phi_1$
Out
$\Phi_2$

$V_R(t)$

$V_{OUT}(t)$

104

Figure 1

$\alpha_{IN}$

$V_{in}$

Figure 2

Figure 3

Figure 4

104-1

Figure 5

Figure 6

104-2

701

702

Figure 7

Figure 8

Figure 9a

Figure 9b

Figure 9c

Figure 10

1110         1120         1130

$V_{IN}$

$\Phi_1$

$Out$

$\Phi_2$

$\dfrac{d}{dt}$

$V_{OUT}$

Figure 11

Normalized gain in dB

2

0

50

-2

-4

-6

-8

-10

-12

500

Modulation frequency

Figure 12

1302         1304

$V_{REF}$

$+$

$-$

$C(p)$

$K_L$

$\alpha_{OUT}(p)$

$\alpha_{DET}$

1306

Figure 13

Figure 14

## RÉFÉRENCES CITÉES DANS LA DESCRIPTION

**Documents brevets cités dans la description**

- US 5650749 A

**Littérature non-brevet citée dans la description**

- **S. OH et al.** An Acoustic Signal Processing Chip With 142-nW Voice Activity Detection Using Mixer-Based Sequential Frequency Scanning and Neural Network Classification. *IEEE Journal of Solid-State Circuits,* Novembre 2019, vol. 54 (11), 3005-3016
- **R. ADLER.** A Study of Locking Phenomena in Oscillators. *Proceedings of the IRE,* Juin 1946, vol. 34 (6), 351-357
- **F. YUAN.** Injection-Locking in Mixed-Mode Signal Processing. Springer, 2020
- **LEENE, LIEUWE B. ; TIMOTHY G. CONSTANDINOU.** Time Domain Processing Techniques Using Ring Oscillator-Based Filter Structures. *IEEE Transactions on Circuits and Systems I: Regular Papers,* 2017, vol. 64, 3003-3012